# FASCICULE DE BREVET EUROPEEN

(11) **EP 0 550 309 B1**
(45) Date de publication et mention de la délivrance du brevet: **24.09.1997**
(21) Numéro de dépôt: 92403448.1
(22) Date de dépôt: 17.12.1992
(51) Int. Cl.: H04B 10/14, H04B 10/24, H01S 3/103

(54) **Photorécepteur non sélectif pour signaux optiques modulés en fréquence et liaison optique utilisant ce photorécepteur**
Nichtselektiver Fotoempfänger für frequenzmodulierte optische Signale und optische Verbindung unter Verwendung dieses Fotoempfänger
Non-selective photoreceiver for frequency modulated optical signals and optical link using the photoreceiver

(30) Priorité: 20.12.1991 FR 9115890
(43) Date de publication de la demande: 07.07.1993
(73) Titulaire: FRANCE TELECOM, 75015 Paris (FR)
(72) Inventeur: Nakajima, Hisao, F-92220 Bagneux (FR)
(74) Mandataire: Signore, Robert

(56) Documents cités:
- EP-A- 0 356 302
- EP-A- 0 420 742
- FR-A- 2 662 883
- GB-A- 2 144 598
- ELECTRONICS LETTERS. vol. 25, no. 14, 6 Juillet 1989, STEVENAGE GB pages 890 - 892 T.L.KOCH ET AL 'Tunable multiple-quantum-well distributed-Bragg-reflector lasers as tunable narrowband receivers'
- LASER FOCUS WORLD. vol. 25, no. 8, Août 1989, TULSA US pages 129 - 133 T.P.LEE 'Diode-laser developers look to broadband optical communications'

## Description

### Domaine technique

La présente invention a pour objet un photorécepteur non sélectif pour signaux optiques modulés en fréquence et une liaison optique utilisant un tel photorécepteur. Elle trouve une application en télécommunications optiques.

### Etat de la technique

Le document FR-A-2 652 465 décrit un photorécepteur consistant en un laser à semiconducteur alimenté nettement au-dessus du seuil. Un signal optique modulé en fréquence est injecté dans ce laser. La tension prélevée aux bornes de celui-ci reflète l'écart de fréquence entre la fréquence du signal optique et la fréquence propre du laser.

Cette technique est également décrite dans l'article de Hisao NAKAJIMA intitulé "Demodulation of Multi-Gigahertz Frequency Modulated Optical Signals in an Injection-Locked Distributed Feedback Laser Oscillator", publié dans Electronics Letters 19th July 1990, vol. 26, n° 15.

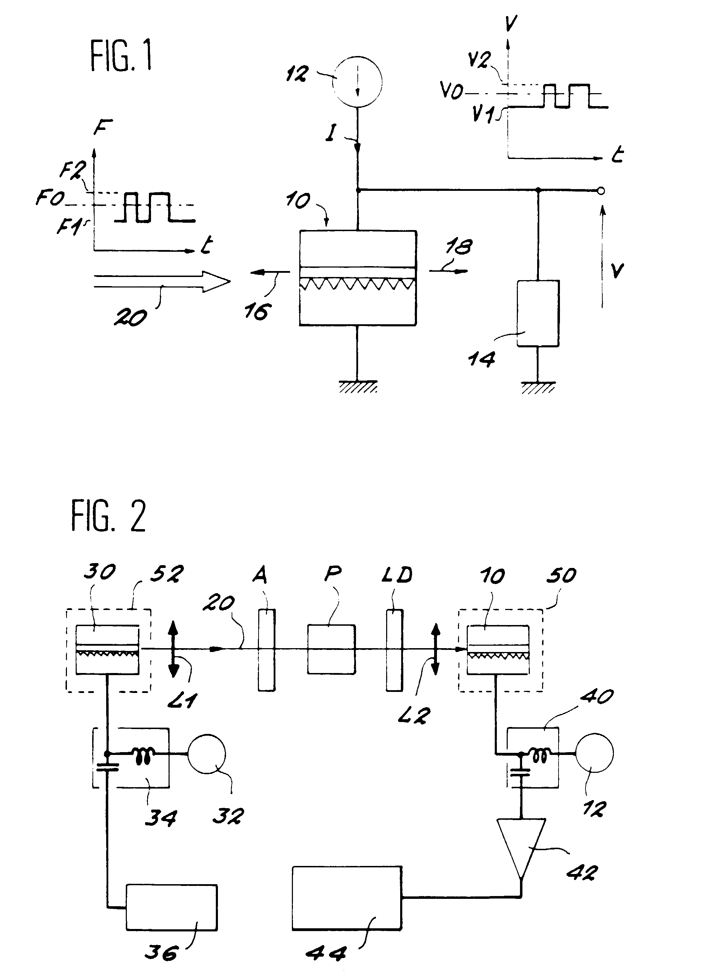

La figure 1 annexée illustre la structure et le fonctionnement de ce photorécepteur.

On voit, sur cette figure, un laser 10, par exemple du type à réaction distribuée ("Distributed Feedback" ou DFB en abrégé). Un tel laser est constitué classiquement d'un empilement de couches semiconductrices, avec notamment une couche active encadrée par deux couches de confinement et un réseau distribué. Le semiconducteur peut appartenir à la famille des composés III-V de type binaire, ternaire ou quaternaire, comme par exemple InGaAsP sur InP. Le laser est alimenté par une source de courant 12 et est équipé d'un moyen 14 apte à mesurer la tension à ses bornes.

Le courant I injecté est supérieur à deux fois le courant de seuil Is du laser. Le laser est ainsi placé dans un régime de fonctionnement en oscillateur. Il émet un rayonnement lumineux 16, 18 ayant une fréquence bien déterminée Fo ou, si l'on veut, une longueur d'onde bien déterminée λo.

Un faisceau lumineux 20, de fréquence F, (ou de longueur d'onde λ) est injecté dans le laser 10. Sa fréquence est censée être modulée. A titre explicatif est représenté, sur la gauche du dessin, un diagramme montrant que la fréquence peut prendre deux valeurs F1 et F2 (F1 peut correspondre à un 0 logique et F2 à un 1 logique, dans un système d'information binaire.

La tension V, prélevée aux bornes du laser par le moyen 14, prend alors deux valeurs V1 et V2 représentées sur la partie droite et correspondant aux deux fréquences F1 et F2.

Dans cet exemple, les fréquences F1 et F2 encadrent la fréquence propre Fo du laser, F2 étant supérieure à Fo. Dans cette hypothèse, la fréquence de fonctionnement du laser récepteur va glisser vers F1 ou vers F2 sous l'effet de l'injection du faisceau 20, ce qui va décaler la tension de fonctionnement vers le bas ou vers le haut.

La figure 2 montre un exemple de liaison optique utilisant ce type de photorécepteur. On y trouve un premier laser 10 alimenté par une source de courant 12, et un second laser 30 jouant le rôle d'émetteur. Ce second laser est alimenté par une source de courant 32 à travers un Té de polarisation 34 comprenant une inductance et un condensateur, celui-ci étant relié à un oscillateur haute fréquence 36. Le courant injecté dans le laser 30 est modulé faiblement en intensité afin d'éviter la modulation d'intensité lumineuse. Il en résulte que le faisceau lumineux émis 20 est modulé en fréquence autour d'une fréquence moyenne.

Des moyens optiques sont en outre prévus pour injecter le faisceau modulé dans le laser 10 jouant le rôle de photorécepteur. Ces moyens comprennent une première lentille L1, un atténuateur A, un isolateur optique P, une lame demi-onde LD et une seconde lentille L2 pouvant être un objectif de microscope.

Quant aux moyens de mesure de la tension aux bornes du laser, ils comprennent, après un Té de polarisation 40 constitué d'une inductance et d'un condensateur, un amplificateur 42 et un analyseur de spectre 44. Cet analyseur donne l'intensité de la composante de tension à la fréquence de modulation du générateur 36.

Le montage comprend encore des moyens de stabilisation en température des lasers, représentés schématiquement par les rectangles en tirets 50 et 52.

Dans cette technique antérieure, le laser récepteur 10 travaille en régime monofréquence. Ceci implique une certaine sélectivité puisque la fréquence du faisceau modulé injecté doit être située dans une plage assez étroite encadrant la fréquence unique Fo du laser photorécepteur. Cette sélectivité peut présenter des avantages dans certains cas (par exemple pour un multiplexage en fréquence), mais entraîne souvent des inconvénients en transmission normale, car elle nécessite que l'on accorde la fréquence du récepteur 10 à celle de l'émetteur 30 (ou l'inverse).

### Exposé de l'invention

La présente invention a justement pour but de remédier à cet inconvénient. A cette fin, elle propose un photorécepteur beaucoup moins sélectif en fréquence, ce qui simplifie grandement sa mise en oeuvre en supprimant le réglage de la plage de réception sur la fréquence d'émission (ou l'inverse).

Pour obtenir ce résultat, le photorécepteur de l'invention utilise un laser fonctionnant en régime multimode longitudinal. On sait que ce régime est obtenu en utilisant une cavité FABRY-PEROT constituée par deux faces réfléchissantes obtenues fréquemment par le clivage et en réglant la longueur de ce résonateur pour que l'intervalle entre modes longitudinaux, (intervalle égal à la quantité c/2nL où c est la vitesse de la lumière, n l'indice du milieu et L la longueur de la cavité FABRY-PEROT), soit supérieur à la largeur de la raie d'émission. Dès lors, le photorécepteur peut fonctionner autour de l'un quelconque des modes longitudinaux du laser, dans des plages de fréquence qui se chevauchent, ce qui conduit à une large bande globale où le fonctionnement est possible. La sélectivité en fréquence a donc disparu. Ainsi, un laser dont la cavité a 4 mm de long n'a plus de sélectivité en fréquence pour un signal d'excursion 9 GHz.

La présente invention a également pour objet une liaison optique, soit unidirectionnelle utilisant un photorécepteur tel qu'il vient d'être défini, soit bidirectionnelle et utilisant deux sous-ensembles comprenant les moyens du photorécepteur de l'invention, chacun pouvant fonctionner en émission ou en réception et ceci soit en alternance, soit en permanence.

### Brève description des dessins

- la figure 1 montre un photorécepteur sélectif de l'art antérieur,
- la figure 2 montre une liaison optique selon l'art antérieur,
- la figure 3 montre un montage expérimental pour l'étude du photorécepteur non sélectif de l'invention,
- la figure 4 montre le spectre de fonctionnement d'un laser multimode,
- la figure 5 montre les variations de tension aux bornes du laser en fonction de l'écart de fréquence du signal optique par rapport à la fréquence des divers modes du laser,
- la figure 6 illustre une liaison optique bidirectionnelle travaillant à l'alternat,
- la figure 7 illustre une liaison optique bidirectionnelle travaillant simultanément dans les deux sens,
- la figure 8 illustre un mode de réalisation d'un sous-ensemble,
- la figure 9 illustre un autre mode de réalisation d'une liaison bidirectionnelle,
- la figure 10 montre une liaison bidirectionnelle utilisant des lasers à deux électrodes.

### Exposé détaillé de modes de réalisation

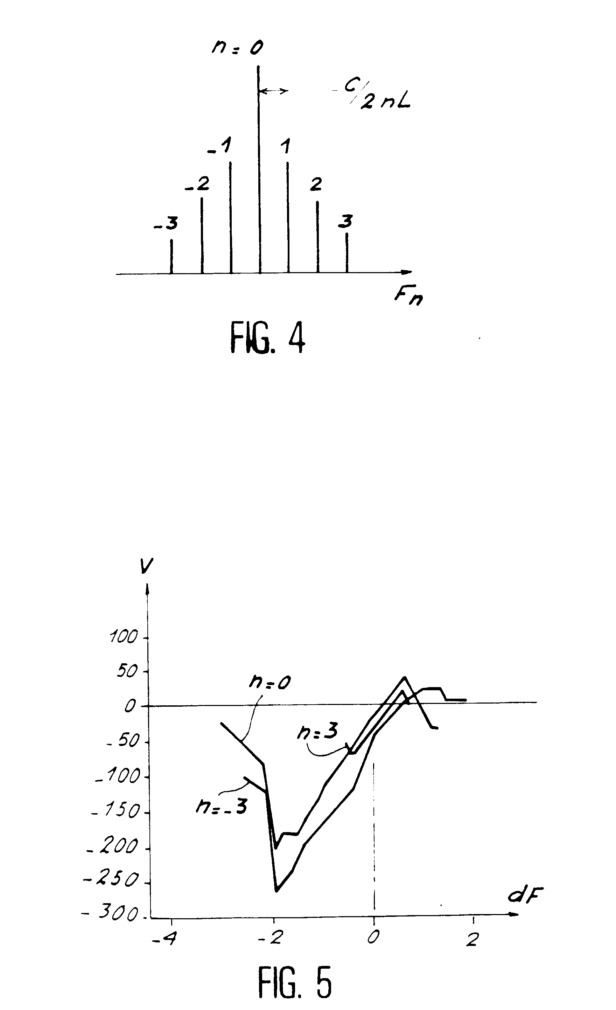

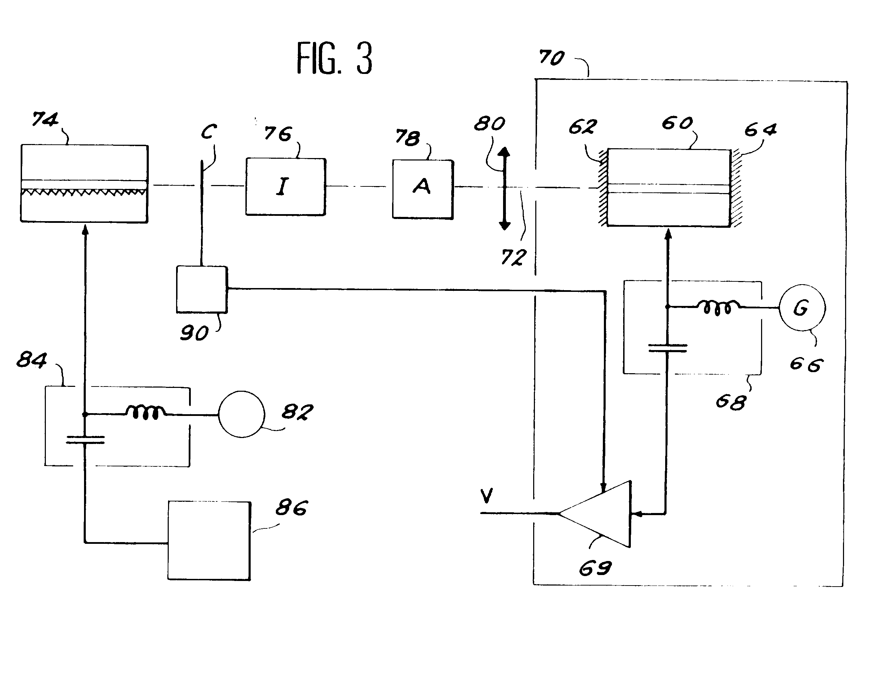

On voit, sur la figure 3, un laser à semiconducteur 60 de type FABRY-PEROT, c'est-à-dire constitué par deux faces réfléchissantes en regard 62 et 64. Sur la figure 3, ces deux faces sont supposées être les faces clivées de la structure semiconductrice mais cette disposition n'est en rien limitative de l'invention. Des miroirs indépendants peuvent fort bien être utilisés. Ce laser 60 est alimenté par une source de courant 66, alimentant le laser très au-dessus du seuil (par exemple 2 à 3 fois le courant de seuil). La source 66 est reliée au laser 60 par un circuit en T 68 comprenant une inductance et un condensateur. Ce circuit est par ailleurs relié à un amplificateur 69 qui délivre une tension V.

Ce premier sous-ensemble, portant la référence générale 70, constitue le photorécepteur de l'invention. Ce photorécepteur reçoit un faisceau lumineux 72 provenant d'une source lumineuse modulée en fréquence et qui, dans l'exemple illustré, est constituée par un laser 74, par exemple de type à réaction distribuée (DFB). Le faisceau lumineux traverse divers éléments optique comme un isolateur 76, un atténuateur 78 et une lentille 80.

Le laser émetteur 74 est alimenté par une source 82 à travers un circuit 84 en T avec une inductance et un condensateur. Une source de modulation 86 permet de moduler faiblement le courant d'alimentation donc de moduler la fréquence d'émission.

Un dispositif de modulation par tout ou rien du faisceau (découpeur ou "chopper") 90 peut être prévu, avec une amplification synchrone au niveau de l'amplificateur 69.

La figure 4 montre les divers modes longitudinaux sur lesquels oscille le laser 60 du photorécepteur. Ces modes peuvent être repérés par un indice n, n, de valeur 0 au centre de la raie d'émission, et de valeurs (+1,-1)/(+2,-2)/(+3,-3)/etc... de part et d'autre du centre de la raie. La fréquence de ces modes est notée Fn. L'écart de fréquence entre deux modes consécutifs est égal à c/2nL et est inversement proportionnel à la longueur L du résonateur FABRY-PEROT.

La figure 5 montre les variations de la tension V prélevée aux bornes du laser 60 et amplifiée par l'amplificateur 69. En abscisses, on trouve l'écart de fréquence dF exprimé en GHz entre la fréquence F du faisceau laser injecté dans le laser et la fréquence Fn de l'un des modes longitudinaux et, en ordonnées, la tension V exprimée en microvolts, délivrée par l'amplificateur 69. On voit, sur la figure 5, la courbe propre au mode n=0 et les courbes propres aux modes extrêmes n=±3. Ces courbes ont chacune la forme caractéristique d'un photorécepteur monomode tel que décrit dans les deux documents cités plus haut. Mais, du fait du caractère multimode, on voit que le photorécepteur de la présente invention est capable de répondre à un signal optique modulé en fréquence lorsque la fréquence de ce signal tombe dans une large plage commençant avant le mode n=-3 et finissant après le mode n=3.

Le photorécepteur qui vient d'être décrit peut être utilisé dans diverses liaisons optiques. Son caractère symétrique (il constitue non seulement un récepteur mais aussi un émetteur) et son absence de sélectivité le rendent particulièrement apte à constituer les deux sous-ensembles présents à chaque extrémité d'une liaison optique, chaque sous-ensemble pouvant travailler en émission et/ou en réception.

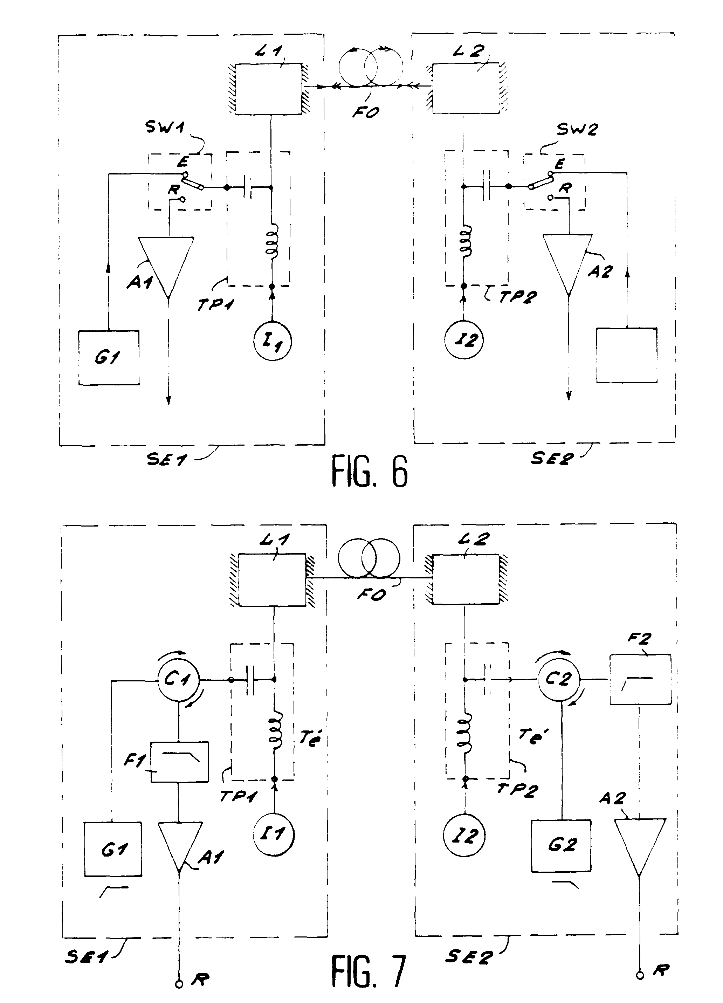

La liaison représentée sur la figure 6 comprend ainsi un premier sous-ensemble SE1 et un second sous-ensemble SE2, tous deux identiques et reliés entre eux par une ou des fibres optiques Fo. Les moyens qui constituent ces sous-ensembles sont référencés par des lettres affectées d'un indice 1 ou 2 selon qu'il s'agit du premier ou du second. On trouve ainsi, dans le sous-ensemble SE1, un laser L1 à résonateur de FABRY-PEROT, une source de courant I1, un Té de polarisation TP1, un générateur de signal G1, un amplificateur A1 et un commutateur SW1 avec une borne E permettant de relier le générateur G1 au laser pour un fonctionnement en émission et une borne R reliant le laser à l'amplificateur A1 pour un fonctionnement en réception.

Le sous-ensemble SE2 comprend les mêmes moyens. Cependant, les commutateurs SW1 et SW2 sont commandés en opposition : si SW1 est sur la position E, SW2 est sur la position R et vice versa. La liaison fonctionne donc tantôt dans un sens (SE1 étant un sous-ensemble émetteur et SE2 un sous-ensemble récepteur) tantôt dans l'autre (SE2 émetteur, SE1 récepteur). La liaison fonctionne donc à l'alternat.

Dans la variante illustrée sur la figure 7, on retrouve les mêmes moyens avec, en outre, dans chaque sous-ensemble, des moyens de filtrage de type passe haut et passe bas. De façon plus précise, dans le sous-ensemble SE1, le générateur G1 travaille sur une plage de fréquence haute et comprend un filtre F1 de type passe bas disposé entre un circulateur C1 et l'amplificateur A1. De manière similaire, le sous-ensemble SE2 comprend un générateur G2 travaillant dans une plage basse (correspondant à la bande du filtre passe bas F1) et un filtre passe haut F2 disposé entre un circulateur C2 et un amplificateur A2.

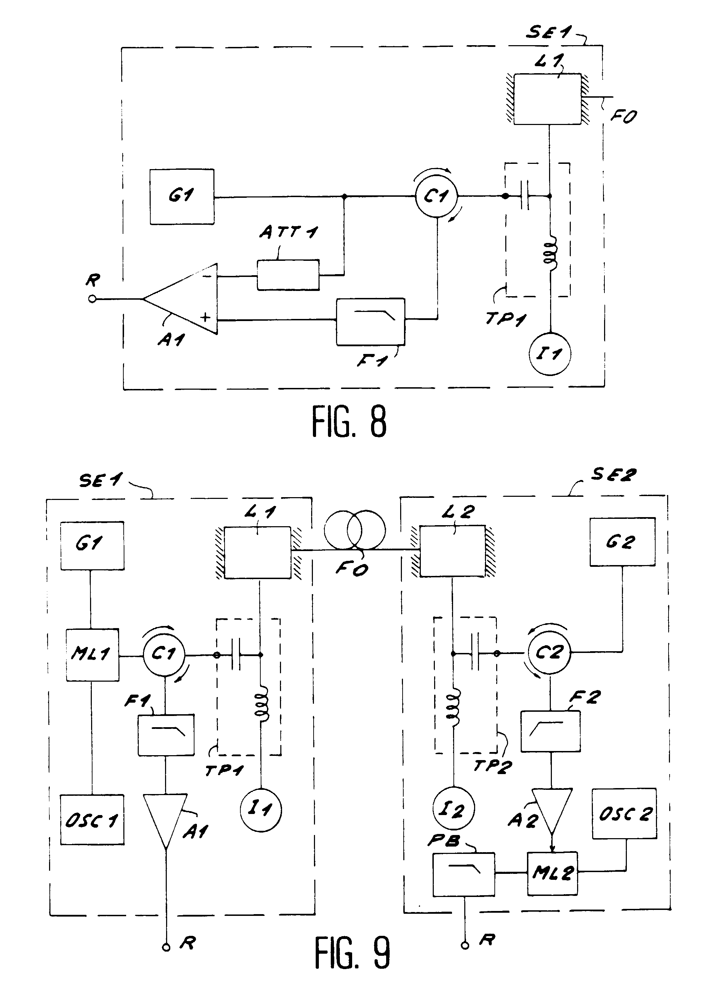

Dans la variante de réalisation illustrée sur la figure 8, chaque sous-ensemble (seul le sous-ensemble SE1 représenté) comprend un atténuateur ATT1 inséré entre le générateur G1 et l'entrée inverseuse (-) de l'amplificateur A1, qui est alors du type amplificateur différentiel, l'entrée directe (+) recevant le signal filtré par F1. Dans cette variante de réalisation, on réussit à minimiser les interférences entre les deux voies de transmission par soustraction des signaux en phase.

Quel que soit le rapport entre la largeur de la bande haute et la largeur de la bande basse, la bande haute peut transmettre plus d'informations que la bande basse. On peut remédier à cette dissymétrie en utilisant, pour la bande haute, la technique du multiplexage de sous-porteuse (en anglais "subcarrier multiplexing" ou SCM). Cela permet également l'utilisation d'un multiplexage en fréquence d'une porteuse, comme illustré sur la figure 9.

Sur cette figure est illustré un mode de réalisation d'un liaison à 250 Mb/s. Cette liaison comprend, en plus des moyens déjà représentés, deux oscillateurs OSC 1 et OSC 2 délivrant une porteuse à 500 MHz et deux mélangeurs ML 1 et ML 2. Le signal émanant du générateur G1 est mélangé à la porteuse à 500 MHz dans le mélangeur ML1 et le résultat est envoyé sur le laser L1 pour modulation. Le signal électrique prélevé aux bornes de L1 est filtré dans F1 et amplifié par A1.

Dans le sous-ensemble SE2, le signal détecté par L2 est d'abord filtré par F2, puis amplifié par A2 et la porteuse à 500 MHz provenant de OSC 2 est soustraite dans ML 2 dans le signal ainsi filtré et amplifié. En revanche, la modulation du laser L2 s'effectue directement par le signal émanant du générateur G2.

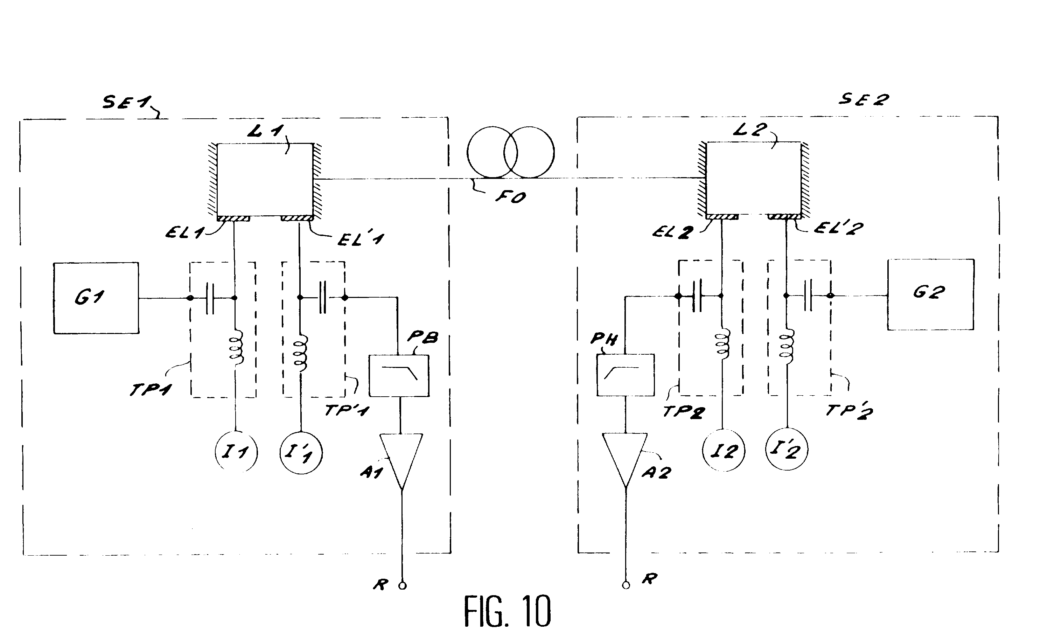

Dans la description qui précède, les lasers utilisés comprennent, implicitement, une seule électrode reliée au Té de polarisation. Mais on ne sortirait pas du cadre de l'invention en utilisant des lasers multi-électrodes, qui sont, en eux-mêmes, des moyens connus. La figure 10 montre, par exemple, une liaison utilisant des lasers à deux électrodes, respectivement (EL 1, EL'1) pour le laser L1 et (EL 2, EL'2) pour le laser L2. Ces électrodes sont reliées à deux Tés de polarisation, (TP1, TP'1) pour le laser L1 et (TP2, TP'2) pour le laser L2, ces Tés étant eux-mêmes reliés à deux sources de courant (I1, I'1) et (I2, I'2).

## Revendications

1. Photorécepteur pour signaux optiques modulés en fréquence, comprenant un laser à semiconducteur (10, 60, L1, L2) avec une couche active, un courant de seuil, une source de courant de polarisation (12, 66, I1, I2) alimentant le laser en courant à une valeur très supérieure au seuil, le laser (10, 60, L1, L2) fonctionnant alors en oscillateur, des moyens optiques (L1, A, P, LD, L2, 76, 78, 86) pour injecter un faisceau lumineux (20, 72) ayant une fréquence F modulée dans la couche active du laser (10, 60, L1, L2), un moyen (14, 42, 61, A1, A2) pour prélever la tension électrique présente aux bornes du laser, ce photorécepteur étant caractérisé par le fait que le laser (60, L1, L2) comprend un résonateur de type FABRY-PER0T (62, 64) et oscille sur plusieurs modes longitudinaux (Mn) de fréquences différentes (Fn).

2. Système de liaison optique monodirectionnelle constituée par :
- un émetteur (SE1, SE2) comprenant un laser à semiconducteur (L1, L2), des moyens (I1, I2) d'alimentation en courant de ce laser (L1, L2) et des moyens (G1, G2) pour moduler en fréquence le faisceau lumineux émis par le laser (L1, L2), et
- un photorécepteur (SE2, SE1) apte à recevoir le faisceau lumineux émis et à délivrer une tension électrique (V) traduisant la modulation de fréquence du faisceau émis par l'émetteur et reçu par le photorécepteur,
cette liaison étant caractérisée par le fait que le photorécepteur (SE2 , SE1) est conforme au photorécepteur de la revendication 1.

3. Système de liaison optique bidirectionnelle constituée par un premier et un second sous-ensembles (SE1, SE2) identiques à laser à semiconducteur (L1, L2), le premier et le second sous-ensembles étant capables de travailler aussi bien en photoémetteur qu'en photorécepteur, caractérisée par le fait que le premier et second sous-ensembles (SE1, SE2) sont constitués par les moyens du photorécepteur de la revendication 1, avec, en outre, respectivement des premiers et seconds moyens de modulation en fréquence (G1, G2) pour travailler en émission.

4. Système de liaison optique bidirectionnelle selon la revendication 3, caractérisée par le fait qu'elle comprend, dans chaque sous-ensemble (SE1, SE2), un commutateur (SW1, SW2) permettant de relier le laser à semiconducteur (L1, L2) soit à un générateur de signal à transmettre (G1, G2) pour un fonctionnement en émission de ce laser, soit à un amplificateur (A1, A2) pour un fonctionnement en réception de ce laser, ces deux commutateurs (SW1, SW2) étant commandés en synchronisme et en opposition, la liaison fonctionnant ainsi à l'alternat, tantôt dans un sens, tantôt dans l'autre.

5. Système de liaison optique bidirectionnelle selon la revendication 3, caractérisée par le fait que les premiers et seconds moyens de modulation (G1, G2) des premier et second sous-ensembles (SE1, SE2) travaillent respectivement dans une bande de fréquence haute et dans une bande de fréquence basse, le premier sous-ensemble (SE1) comprenant en outre un filtre passe bas (F1) inséré dans les moyens de prélèvement de la tension aux bornes du premier laser (L1) et le second sous-ensemble (SE2) comprenant en outre un filtre passe haut (F2) inséré dans les moyens de prélèvement de la tension aux bornes du second laser (L2), la liaison fonctionnant ainsi simultanément dans les deux sens.

6. Système de liaison optique selon l'une quelconque des revendications 2 à 5, caractérisée par le fait que le laser (L1, L2) de chaque sous-ensemble (SE1, SE2) est à multiélectrode.

## Patentansprüche

1. Photoempfänger für frequenzmodulierte optische Signale, umfassend einen Halbleiter-Laser (10, 60, L1, L2) mit einer aktiven Schicht, einem Schwellenstrom, einer Vorspannungsquelle (12, 66, I1, I2), die den Laser mit einem Strom eines sehr viel höheren Werts als dem Schwellwert versorgt, wobei der Laser (10, 60, L1, L2) dann als Oszillator funktioniert, optische Einrichtungen (L1, A, P, LD, L2, 76, 78, 86) zum Einspeisen eines Lichtbündels (20, 72) mit einer modulierten Frequenz F in die aktive Schicht des Lasers (10, 60, L1, L2), eine Einrichtung (14, 42, 61, A1, A2) zum Abgreifen der elektrischen Spannung an den Anschlüssen des Lasers, wobei dieser Photoempfänger
**dadurch gekennzeichnet** ist, daß der Laser (60, L1, L2) einen Resonator des Typs FABRY-PEROT enthält und auf mehreren Longitudinalmoden (Mn) unterschiedlicher Frequenzen (Fn) schwingt.

2. Optisches Einrichtungs-Verbindungssystem, gebildet durch:
- einen. Sender (SE1, SE2) mit einem Halbleiter-Laser (L1, L2), Stromversorgungseinrichtungen (I1, I2) dieses Lasers und Einrichtungen (G1, G2), um die Frequenz des durch den Laser (L1, L2) ausgestrahlten Lichtbündels zu modulieren, und
- einen Photoempfänger (SE2, SE1), um das ausgestrahlte Lichtbündel zu empfangen und um eine elektrische Spannung (V) zu liefern, die die Frequenzmodulation des durch den Sender ausgestrahlten und durch den Photoempfänger empfangenen Bündels ausdrückt,
wobei diese Verbindung dadurch gekennzeichnet ist, daß der Photoempfänger (SE1, SE2) dem Photoempfänger des Anpspruchs 1 entspricht.

3. Optisches Zweirichtungs-Verbindungssystem, gebildet durch zwei identische Teilsysteme (SE1, SE2) mit Halbleiter-Lasern (L1, L2), wobei beide Teilsysteme fähig sind, sowohl als Photosender wie als Photoempfänger zu arbeiten, dadurch gekennzeichnet, daß beide Teilsysteme (SE1, SE2) durch die Photoempfängereinrichtungen des Anspruchs 1 gebildet werden, mit außerdem jeweils einer Frequenzmodulationseinrichtung (G1, G2), um als Sender zu arbeiten.

4. Optisches Zweirichtungs-Verbindungssystem nach Anspruch 3, dadurch gekennzeichnet, daß es in jedem Teilsystem (SE1, SE2) einen Schalter (SW1, SW2) gibt, der ermöglicht, den Halbleiterlaser (L1, L2) entweder mit einem Generator (G1, G2) eines zu übertragenden Signals für einen Sendebetrieb dieses Lasers oder mit einem Verstärker (A1, A2) für einen Empfangsbetrieb dieses Lasers zu verbinden, wobei diese beiden Schalter (SW1, SW2) synchron und entgegengesetzt gesteuert werden, so daß die Verbindung im Wechselbetrieb arbeitet, mal in der einen Richtung, mal in der anderen.

5. Optisches Zweirichtungs-Verbindungssystem nach Anspruch 3, dadurch gekennzeichnet, daß die erste (G1) und die zweite (G2) Modulationseinrichtung des ersten (SE1) und zweiten (SE2) Teilsystems jeweils in einem hohen und einem niedrigen Frequenzband arbeiten, wobei das erste Teilsystem (SE1) außerdem ein Tiefpaßfilter (F1) umfaßt, eingeschaltet in die Abgreifeinrichtungen der Spannung an den Anschlüssen des ersten Lasers (L1), und das zweite Teilsystem (SE2) außerdem ein Hochpaßfilter (F2) umfaßt, eingeschaltet in die Abgreifeinrichtungen der Spannung an den Anschlüssen des zweiten Lasers (L2), wobei die Verbindung infolgedessen simultan in beiden Richtungen funktioniert.

6. Optisches Verbindungssystem nach einem der Ansprüche 2 bis 5, dadurch gekennzeichnet, daß der Laser (L1, L2) von jedem Teilsystem (SE1, SE2) eine Vielzahl Elektroden aufweist bzw. ein Multi-Elektroden-Laser ist.

## Claims

1. Photoreceiver for frequency-modulated optical signals, comprising a semiconductor laser (10,60, L1,L2) with an active layer, a threshold current, a polarization current supply (12,66,I1,I2) supplying the laser with current at a value well above the threshold, the laser (10, 60, L1, L2) then functioning as an oscillator, optical means (L1, A, P, LD, L2, 76, 78, 86) for injecting a light beam (20, 72) having a frequency F modulated in the active layer of the laser (10,60, L1, L2), a means (14,42,61, A1, A2) for sampling the voltage present at the laser terminals, said photoreceiver being characterized in that the laser (60, L1, L2) comprises a FABRY-PEROT-type resonator (62,64) and oscillates on several longitudinal modes (Mn) of different frequencies (Fn).

2. Monodirectional optical link system constituted by an emitter (SE1, SE2 having a semiconductor laser (L2, L2), means (I1, I2) for supplying current to said laser (L1, L2) and means (G1, G2) for the frequency modulation of the light beam emitted by the laser (L1, L2) and a photoreceiver (SE2, SE1) able to receive the light beam emitted and supply a voltage (V) representing the frequency modulation of the beam emitted by the emitter and received by the photoreceiver, said link being characterized in that the photoreceiver (SE2, SE1) complies with the photoreceiver of claim 1.

3. Bidirectional optical link system constituted by a first and a second identical subassemblies (SE1, SE2) having a semiconductor laser (L1, L2), the first and second subassemblies being able to operate both as a photoemitter and as a photoreceiver, characterized in that the first and second subassemblies (SE1, SE2) are constituted by the photoreceiver means of claim 1 with, additionally, respectively first and second frequency modulation means (G1, G2) for operating in emission.

4. Bidirectional optical link system according to claim 3, characterized in that it comprises, in each subassembly (SE1, SE2), a switch (SW1, SW2) making it possible to connect the semiconductor laser (L1, L2) either to a generator of a signal to be transmitted (G1, G2) for emission operation of the laser, or to an amplifier (A1, A2) for a laser reception operation, said two switches (SW1, SW2) being controlled in synchronism and opposition, so that the link operates in alternating manner, sometimes in one direction and sometimes in the other.

5. Bidirectional optical link system according to claim 3, characterized in that the first and second modulation means (G1, G2) of the first and second subassemblies (SE1, SE2) respectively operate in a high and a low frequency band, the first subassembly (SE1) also having a low pass filter (F1) inserted in the means for sampling the voltage at the terminals of the first laser (L1) and the second subassembly (SE2) also having a high pass filter (F2) inserted in the means for sampling the voltage at the terminals of the second laser (L2), so that the link simultaneously operates in both directions.

6. Optical link system according to any one of the claims 2 to 5, characterized in that the laser (L1, L2) of each subassembly (SE1, SE2) is of the multielectrode type.
